# EUROPEAN PATENT APPLICATION

(11) **EP 2 725 364 A1**
(43) Date of publication of application: **30.04.2014**
(21) Application number: 11868278.0
(22) Date of filing: 22.06.2011
(51) Int. Cl.: G01R 1/067

(54) **SPIRAL PROBE AND MANUFACTURING METHOD FOR SAME**

(71) Applicant: Meiko Electronics Co., Ltd., Ayase-shi, Kanagawa 252-1104 (JP)
(72) Inventor: SHINGAI, Noboru, Ayase-shi, Kanagawa 252-1104 (JP)
(74) Representative: Epping - Hermann - Fischer
(86) International application number: PCT/JP2011/064238
(87) International publication number: WO 2012/176289

(57) **Abstract**

A spiral probe includes a tapered distal end portion (2) configured to be brought into direct contact with an inspection object, a hollow, nearly cylindrical distal body (3) extending in one direction from the base of the distal end portion (2), a hollow, nearly cylindrical flexible portion (4) integral with and continuously extending in the one direction from the distal body (3) and having a spiral outer peripheral surface, and a hollow, nearly cylindrical proximal end portion (5) integral with and continuously extending in the one direction from the flexible portion (4), wherein the distal body (3), the flexible portion (4) and the proximal end portion (5) have outer peripheral surfaces aligned with each other in the one direction.

## Description

### Technical Field

The present invention relates to a spiral probe and a method of manufacturing the spiral probe.

### Background Art

Miniaturization of electronic components and densification of component packaging through the use of increased numbers of pins (BGA) in semiconductor packages have been advancing in order to reduce size, weight and thickness of various electronic devices and to attain multi-functional capabilities. Consequently, the pitches of conductor patterns are becoming narrower and narrower to cope with multi-functionality and speeding-up of electronic devices as a result of miniaturization, and more and more stringent requirements have come to be imposed on the resistance between conductors, or inter-conductor resistance.

Thus, smaller-sized probes have also come to be used as inspection devices for inspecting various parameters of highly densely packaged electronic components and accurately measuring the inter-conductor resistance and the like of high-density conductor patterns.

Such a probe is disclosed in Patent Document 1. The probe disclosed in Patent Document 1 includes a pair of plungers connected by a spring interposed between the plungers. The disclosed structure using a spring interposed between separate plungers is, however, difficult to fabricate and the operation is also not easy. Conventional probes available can be used for inspection of pitches of 0.2 mm and more and, in the case of grid arrays, can be used only for inspection of pitches of 0.3 mm and more.

### Citation List

### Patent Literature

Patent Document 1: PCT International Application-Japanese Translation No. 2004-503783

### Summary of Invention

### Technical Problem

The present invention provides a spiral probe which is easy to manufacture, which, when used in a probe unit, permits the spacing between the probes to be reduced, and which can cope with miniaturization of electronic components, and a method of manufacturing the spiral probe.

### Solution to Problem

The present invention provides a spiral probe comprising: a tapered distal end portion configured to be brought into direct contact with an inspection object to be inspected; a hollow, nearly cylindrical distal body extending in one direction from a base of the distal end portion; a hollow, nearly cylindrical flexible portion integral with and continuously extending in the one direction from the distal body and having a spiral outer peripheral surface; and a hollow, nearly cylindrical proximal end portion integral with and continuously extending in the one direction from the flexible portion, wherein the distal body, the flexible portion and the proximal end portion have outer peripheral surfaces aligned with each other in the one direction.

Preferably, the distal end portion, the distal body, the flexible portion and the proximal end portion are all made of an identical material, and the material is any one of nickel, gold alloy containing nickel or cobalt, a two-layer material having a gold film laminated on a nickel film, and nickel-tin alloy.

The present invention also provides a method of manufacturing the spiral probe, comprising: subjecting a fine wire member, which is a fine wire of metal, to plating process by immersing the fine wire member, except one end portion thereof, in a plating solution to form a nearly cylindrical coating layer closed at a distal end thereof and having an outer peripheral surface extending parallel to an axis thereof; subjecting the coating layer to machining process to form the distal end portion at an end portion of the coating layer corresponding to the closed distal end; removing part of the coating layer to form the flexible portion as well as the distal body and the proximal end portion; and immersing the fine wire member with the distal body, the flexible portion and the proximal end portion thereon in an etching solution to dissolve all of the fine wire member.

Preferably, the other end portion of the fine wire member has a tapered shape.

The coating layer is preferably removed in part by laser beam machining.

### Advantageous Effects of Invention

According to the present invention, the outer peripheral surfaces of the distal body, flexible portion and proximal end portion are aligned with each other in the one direction, and it is therefore possible to provide an ultra-fine probe. When a probe unit is assembled using the probes, the spacing between the probes can be reduced, enabling the probe unit to handle smaller-sized electronic components and the like.

Also, the spiral probe of the present invention is formed as a one-piece member using only the coating layer, and thus it is possible to efficiently manufacture the probe following a sequence of steps.

### Brief Description of Drawings

FIG. 1 schematically illustrates a spiral probe according to the present invention.
FIG. 2 is a schematic diagram illustrating a method of manufacturing the spiral probe of the present invention in order.
FIG. 3 is a schematic diagram illustrating the method of manufacturing the spiral probe of the present invention in order.
FIG. 4 is a schematic diagram illustrating the method of manufacturing the spiral probe of the present invention in order.
FIG. 5 is a schematic diagram illustrating the method of manufacturing the spiral probe of the present invention in order.
FIG. 6 schematically illustrates another spiral probe according to the present invention.

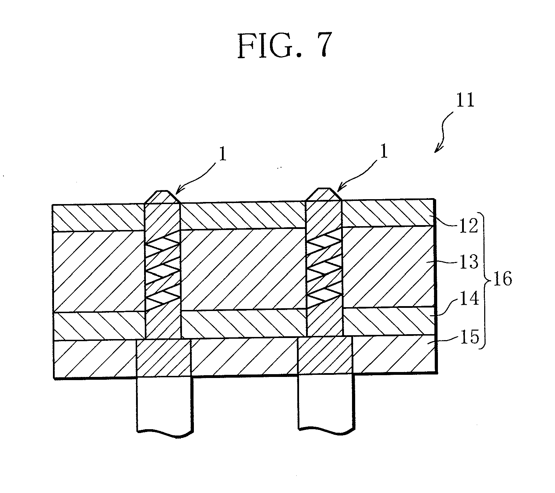

FIG. 7 schematically illustrates a probe unit using the spiral probes of the present invention.

### Description of Embodiments

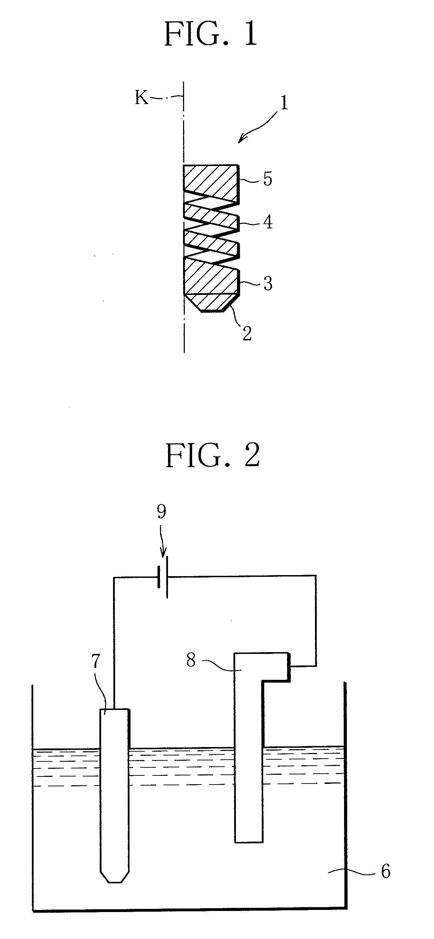

As illustrated in FIG. 1, a spiral probe 1 according to the present invention has a tapered distal end portion 2 at a tip thereof, the distal end portion 2 being brought into direct contact with an inspection object to be inspected. The probe 1 also has a hollow distal body 3 having a nearly cylindrical shape and extending in one direction from the base of the distal end portion 2. Further, the probe 1 has a flexible portion 4 integral with and continuously extending in the one direction from the distal body 3. The flexible portion 4 has a hollow, nearly cylindrical shape and has a spiral outer peripheral surface. The probe 1 further has a hollow proximal end portion 5 having a nearly cylindrical shape and integral with and continuously extending in the one direction from the flexible portion 4.

The spiral probe 1 having such a configuration is produced in the manner described below.

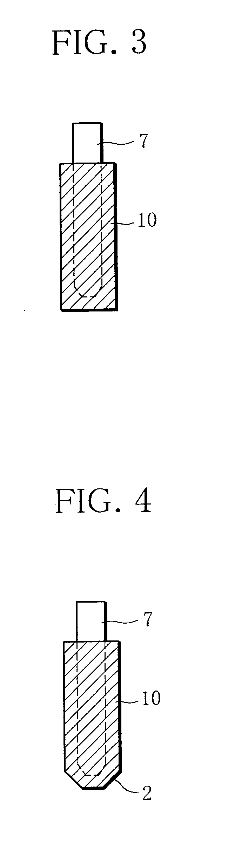

First, as illustrated in FIG. 2, a fine wire member 7, which is a fine wire of metal, is immersed in a plating solution 6. The fine wire member 7 is made of copper, for example, and has a diameter of 50 µm. The fine wire member 7 has a predetermined length and is immersed, except one end portion thereof, in the plating solution 6. An electrode 8 is also immersed in the plating solution and electrically connected to the fine wire member 7 via a power supply 9. Nickel ions are present in the plating solution. Thus, when applied with voltage, the fine wire member 7 undergoes electroplating, and a coating layer 10 is formed on the outside of the fine wire member 7, as shown in FIG. 3. The coating layer 10 has a nearly cylindrical shape closed at a distal end (in FIG. 3, at a lower end) thereof and has an outer peripheral surface extending parallel to and at a constant distance from a longitudinal axis thereof. The thickness of the coating layer can be controlled by varying the plating time and the applied voltage (current).

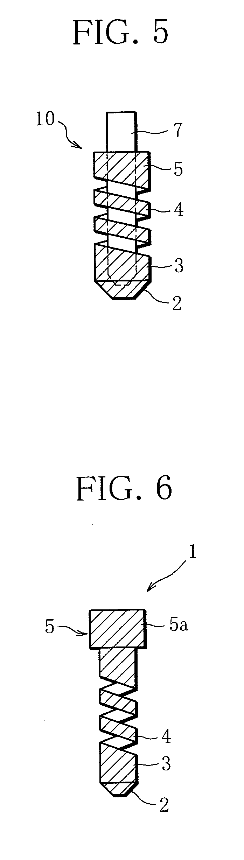

Then, as illustrated in FIG. 4, the distal end portion 2 is formed. The distal end portion 2 is formed at the distal end portion of the coating layer 10 by a machining process using a machine known in the art. Specifically, the distal end portion of the coating layer 10 is machined into a tapered shape. It is preferable that the distal end portion of the fine wire member 7 have a tapered shape, because such a tapered shape facilitates the machining. Subsequently, as illustrated in FIG. 5, part of the coating layer 10 is removed to form the flexible portion 4. The flexible portion 4 is formed by spiral removal of the outer periphery of the coating layer 10 with use of a laser beam from a laser beam machine known in the art (laser trimming). The wavelength of the laser beam to be used is preferably 532 nm but may be varied depending upon the material of the coating layer 10. The distal body 3 and the proximal end portion 5 are formed concurrently with the flexible portion 4.

The fine wire member 7 with the coating layer, namely, the distal body 3, the flexible portion 4 and the proximal end portion 5, is then immersed in a selective etching solution (not shown). The selective etching solution dissolves only the material of the fine wire member 7 (in this instance, copper). Since the fine wire member 7 is dissolved, only the spiral probe 1 constituted by the coating layer 10, that is, the spiral probe 1 having the distal end portion 2, the distal body 3, the flexible portion 4 and the proximal end portion 5 is left (the state shown in FIG. 1). In this manner, the coating layer 10 alone is used to form the spiral probe 1. Since the probe 1 is formed as a one-piece member using the coating layer 10, it is possible to efficiently manufacture the probe 1 following a sequence of steps.

In the probe 1 thus produced, the outer peripheral surfaces of the distal body 3, flexible portion 4 and proximal end portion 5 are aligned with each other in one direction. More specifically, the outer peripheral surfaces of the distal body, flexible portion and proximal end portion all extend in parallel to and at a constant distance from the longitudinal axis of the probe. That is to say, the outer peripheral surfaces of all portions of the probe 1 except the distal end portion extend along an imaginary line K parallel to the axis of the probe 1 (see FIG. 1). It is therefore possible to obtain an ultra-fine probe 1. Where the plating thickness is set to 8 µm and the fine wire has a diameter φ of 50 µm, for example, it is possible to obtain a probe 1 with an outer diameter φ of 66 µm. Accordingly, the probe can be used for inspection of pitches as small as 100 µm, significantly smaller than pitches that can be inspected with conventional probes. That is, when a probe unit is assembled using the probes 1, the spacing between the probes 1 can be reduced, thus enabling the probe unit to handle smaller-sized electronic components and the like. Such a small pitch cannot be handled by conventional spring probes or wire probes.

Also, the probe 1 is made in its entirety of the same material. The material to be used may be nickel, gold alloy containing nickel or cobalt, a two-layer material having a gold film laminated on a nickel film, or nickel-tin alloy. Whichever material is used, the small-sized probe 1 has elasticity to some extent and thus can be deformed in its longitudinal direction.

The fine wire member 7 of which the one end portion has an increased diameter may be used so that the probe obtained may have a large-diameter portion 5a as an outermost edge of the proximal end portion 5, as shown in FIG. 6. By configuring the probe such that the proximal end portion 5 has portions with different diameters, it is possible to apply the probe to a variety of probe units.

A probe unit 11 using the probes 1 is fabricated by causing the probes 1 to penetrate through a four-layer support 16 including a stack of a distal end guide member 12, a flexible portion guide member 13, a proximal end guide member 14 and an input/output lead guide member 15. The distal end guide member 12 and the flexible portion guide member 13 may be made of the same material, and the proximal end guide member 14 and the input/output lead guide member 15 may be made of the same material. In this case, the support 16 has a three- or two-layer structure.

### Reference Signs List

- 1:: spiral probe
- 2:: distal end portion
- 3:: distal body
- 4:: flexible portion
- 5:: proximal end portion
- 6:: plating solution
- 7:: fine wire member
- 8:: electrode
- 9:: power supply
- 10:: coating layer
- 11:: probe unit
- 12:: distal end guide member
- 13:: flexible portion guide member
- 14:: proximal end guide member
- 15:: input/output lead guide member
- 16:: support

## Claims

1. A spiral probe comprising:
a tapered distal end portion configured to be brought into direct contact with an inspection object to be inspected;
a hollow, nearly cylindrical distal body extending in one direction from a base of the distal end portion;
a hollow, nearly cylindrical flexible portion integral with and continuously extending in the one direction from the distal body and having a spiral outer peripheral surface; and
a hollow, nearly cylindrical proximal end portion integral with and continuously extending in the one direction from the flexible portion,
wherein the distal body, the flexible portion and the proximal end portion have outer peripheral surfaces aligned with each other in the one direction.

2. The spiral probe according to claim 1, wherein:
the distal end portion, the distal body, the flexible portion and the proximal end portion are all made of an identical material, and
the material is any one of nickel, gold alloy containing nickel or cobalt, a two-layer material having a gold film laminated on a nickel film, and nickel-tin alloy.

3. A method of manufacturing the spiral probe according to claim 1, comprising:
subjecting a fine wire member, which is a fine wire of metal, to plating process by immersing the fine wire member, except one end portion thereof, in a plating solution to form a nearly cylindrical coating layer closed at a distal end thereof and having an outer peripheral surface extending parallel to an axis thereof;
subjecting the coating layer to machining process to form the distal end portion at an end portion of the coating layer corresponding to the closed distal end;
removing part of the coating layer to form the flexible portion as well as the distal body and the proximal end portion; and
immersing the fine wire member with the distal body, the flexible portion and the proximal end portion thereon in an etching solution to dissolve all of the fine wire member.

4. The method according to claim 3, wherein the other end portion of the fine wire member has a tapered shape.

5. The method according to claim 3, wherein the coating layer is removed in part by laser beam machining.
